(19) Europäisches Patentamt
European Patent Office
Office européen des brevets

(11) **EP 4 513 526 A1**

(12) **EUROPÄISCHE PATENTANMELDUNG**

(43) Veröffentlichungstag:
**26.02.2025   Patentblatt 2025/09**

(21) Anmeldenummer: **23193463.9**

(22) Anmeldetag: **25.08.2023**

(51) Internationale Patentklassifikation (IPC):
**H01J 37/26** *(2006.01)*          **G03H 1/04** *(2006.01)*
**G03H 5/00** *(2006.01)*

(52) Gemeinsame Patentklassifikation (CPC):
**H01J 37/265;** G03H 1/0443; G03H 5/00;
H01J 2237/2614

(84) Benannte Vertragsstaaten:
**AL AT BE BG CH CY CZ DE DK EE ES FI FR GB
GR HR HU IE IS IT LI LT LU LV MC ME MK MT NL
NO PL PT RO RS SE SI SK SM TR**
Benannte Erstreckungsstaaten:
**BA**
Benannte Validierungsstaaten:
**KH MA MD TN**

(71) Anmelder: **Technische Universität Berlin
10623 Berlin (DE)**

(72) Erfinder: **WAGNER, Tolga
12169 Berlin (DE)**

(74) Vertreter: **Fischer, Uwe
Patentanwalt
Moritzstraße 22
13597 Berlin (DE)**

(54) **VORRICHTUNG ZUR DURCHFÜHRUNG EINER INTERFEROMETRISCHEN MESSUNG**

(57)     Die Erfindung bezieht sich unter anderem auf eine Vorrichtung (10) zur Durchführung einer interferometrischen Messung mit einer Quelle (20) zur Erzeugung von mindestens zwei kohärenten Wellen (OW, RW), einer Überlappungseinrichtung (40) zum Überlappen der mindestens zwei kohärenten Wellen (OW, RW) und zum Erzeugen eines Interferenzmusters (IP), einer Messeinrichtung (50) zum Messen des Interferenzmusters (IP) unter Bildung gemessener Interferenzwerte (I(x,y)), einer Störeinrichtung (61) zum Stören des Interferenzmusters und einem Analysator (70) zum Analysieren der gemessenen Interferenzwerte (I(x,y)), wobei die Überlappungseinrichtung (40) einen von einem Randelement (42) randseitig begrenzten Passierbereich (PB), der von den mindestens zwei sich überlappenden kohärenten Wellen passiert wird, und ein strahlteilendes Element (41) im Mittenbereich des Passierbereiches umfasst. Erfindungsgemäß ist vorgesehen, dass das Randelement (42) einen elektrisch leitfähigen Mantelabschnitt (100) mit einem Durchgangsloch (110) aufweist, dessen Innenwand (112) von einer im Durchgangsloch (110) befindlichen Steuerelektrode (200) des Randelements (42) durch einen Isolator (300) elektrisch getrennt ist, und die Störeinrichtung (61) mit der Steuerelektrode (200) elektrisch in Verbindung steht und geeignet ist, zur Störung der Interferenz eine elektrische Spannung zwischen den Mantelabschnitt (100) und die Steuerelektrode (200) anzulegen.

Fig.1

**(Forts. nächste Seite)**

Fig.7

## Beschreibung

Die Erfindung bezieht sich auf eine Vorrichtung zur Durchführung einer interferometrischen Messung mit einer Quelle zur Erzeugung von mindestens zwei kohärenten Wellen, einer Überlappungseinrichtung zum Überlappen der mindestens zwei kohärenten Wellen und zum Erzeugen eines Interferenzmusters, einer Messeinrichtung zum Messen des Interferenzmusters unter Bildung gemessener Interferenzwerte, einer Störeinrichtung zum Stören des Interferenzmusters und einem Analysator zum Analysieren der gemessenen Interferenzwerte, wobei die Überlappungseinrichtung einen von einem Randelement randseitig begrenzten Passierbereich, der von den mindestens zwei sich überlappenden kohärenten Wellen passiert wird, und ein strahlteilendes Element im Mittenbereich des Passierbereiches umfasst. Eine solche Vorrichtung ist in der Europäischen Offenlegungsschrift EP 3 376 522 A1 offenbart.

Der Erfindung liegt die Aufgabe zugrunde, eine Vorrichtung der beschriebenen Art mit Blick auf eine besonders effiziente Möglichkeit der Einflussnahme auf die Wellen und das Interferenzmuster weiterzuentwickeln.

Diese Aufgabe wird erfindungsgemäß durch eine Vorrichtung mit den Merkmalen gemäß Patentanspruch 1 gelöst. Vorteilhafte Ausgestaltungen der erfindungsgemäßen Vorrichtung sind in Unteransprüchen angegeben.

Danach ist erfindungsgemäß vorgesehen, dass das Randelement einen elektrisch leitfähigen Mantelabschnitt mit einem Durchgangsloch aufweist, dessen Innenwand von einer im Durchgangsloch befindlichen Steuerelektrode des Randelements durch einen Isolator elektrisch getrennt ist, und die Störeinrichtung mit der Steuerelektrode elektrisch in Verbindung steht und geeignet ist, zur Störung der Interferenz eine elektrische Spannung zwischen den Mantelabschnitt und die Steuerelektrode anzulegen.

Ein wesentlicher Vorteil der erfindungsgemäßen Vorrichtung besteht darin, dass durch die vorgeschlagene randseitige Ansteuerung des Randelements die Interferenz deutlich effizienter beeinflussbar ist als bei der in der zitierten Offenlegungsschrift beschriebenen mittigen Ansteuerung des strahlteilenden Elements.

Ein weiterer wesentlicher Vorteil der erfindungsgemäßen Vorrichtung besteht darin, dass sich durch die im Durchgangsloch des Mantelabschnitts geführte Steuerelektrode Radio- oder Mikrowellen mit hoher Amplitude und geringen Verlusten einspeisen lassen, wodurch ein besonders hoher Phasenhub bei der Interferenzmusterverschiebung erreichbar wird.

Die Vorrichtung ist vorzugsweise eine Elektronenholografiemesseinrichtung. Demgemäß handelt es sich bei der Quelle vorzugsweise um eine Elektronenquelle und bei den kohärenten Wellen um Elektronenwellen.

Vorteilhaft ist es, insbesondere aus Symmetriegründen, wenn sich die Mittelachse des Durchgangslochs (und damit die Mittelachse der Steuerelektrode) in Richtung des strahlteilenden Elements erstreckt und eine fiktive Verbindungslinie zwischen einem dem Passierbereich zugewandten Elektrodenende der Steuerelektrode und einem zu diesem nächstliegenden Abschnitt des strahlteilenden Elements auf der Mittelachse liegt.

Ein an den Passierbereich angrenzender Endabschnitt des Durchgangslochs ist vorzugsweise isolatorfrei. Ein isolatorfreier Endabschnitt unterstützt die Ausbildung eines ausgeprägten interferenzstörenden Feldes in dem an das Randelement angrenzenden Passierbereich.

Die Länge des isolatorfreien Endabschnitts liegt vorzugsweise zwischen dem 0,75-Fachen und 1,25-Fachen des Durchmessers der Steuerelektrode.

Ein dem Passierbereich zugewandtes Elektrodenende der Steuerelektrode liegt vorzugsweise im Inneren des Durchgangslochs (also nach innen hinein versetzt im Mantelabschnitt) und weist vorzugsweise einen Abstand von der den Passierbereich begrenzenden Außenfläche des Mantelabschnitts auf.

Der Abstand zwischen dem Elektrodenende und der Außenfläche des Mantelabschnitts liegt vorzugsweise zwischen dem 0,5-Fachen und 1,0-Fachen des Durchmessers der Steuerelektrode.

Als besonders vorteilhaft wird es angesehen, wenn die Steuerelektrode einen sich in Richtung des Passierbereiches verjüngenden Endbereich aufweist. Durch eine Verjüngung des Endbereichs lässt sich die räumliche Feldverteilung des interferenzstörenden Feldes steuern und somit bezüglich des Störeffekts auf den Passierbereich optimieren.

Die Länge des verjüngenden Endbereichs ist - entlang der Längsachse des Durchgangslochs gesehen - vorzugsweise kleiner als die Hälfte des Durchmessers der Steuerelektrode.

Der Endbereich ist vorzugsweise rotationssymmetrisch.

Bezüglich der Verjüngung des Endbereichs wird es als vorteilhaft angesehen, wenn sich dieser konisch verjüngt. Vorteilhaft ist es beispielsweise, wenn der Endbereich kreiskegel- oder kreiskegelstumpfförmig ist.

Bei einer anderen vorteilhaften Ausgestaltung ist vorgesehen, dass die äußere Fläche des Endbereichs radial nach innen, beispielsweise in Richtung einer Rotationsachse radial nach innen, gewölbt ist. Durch die Wölbung lässt sich das elektrische Feld in seiner Form sehr einfach den jeweiligen Bedürfnissen anpassen.

Der Wölbungsradius der Wölbung ist vorzugsweise kleiner als der Durchmesser der Steuerelektrode.

Dem Randelement liegt vorzugsweise ein Zusatzrandelement gegenüber; das strahlteilende Element ist vorzugsweise zwischen dem Randelement und dem Zusatzrandelement angeordnet, beispielsweise mittig und symmetrisch zur Mittelachse der Steuerelektrode.

Der Außendurchmesser des Mantelabschnitts des Randelements und der Außendurchmesser des Zusatzrandelements sind vorzugsweise gleich groß.

Das Zusatzrandelement liegt vorzugsweise auf demselben elektrischen Potential wie der Mantelabschnitt des Randelements.

Die Erfindung bezieht sich außerdem auf eine Überlappungseinrichtung, die einen von einem Randelement randseitig begrenzten Passierbereich und ein strahlteilendes Element im Mittenbereich des Passierbereiches umfasst. Eine solche Überlappungseinrichtung ist aus der eingangs genannten Offenlegungsschrift bekannt.

Erfindungsgemäß ist bezüglich der Überlappungseinrichtung vorgesehen, dass das Randelement einen elektrisch leitfähigen Mantelabschnitt mit einem Durchgangsloch aufweist, dessen Innenwand von einer im Durchgangsloch befindlichen Steuerelektrode des Randelements durch einen Isolator elektrisch getrennt ist, und die Steuerelektrode einen Anschluss aufweist, an den zur Störung einer Interferenz ein elektrisches Potential anlegbar ist, das sich vom elektrischen Potential an dem Mantelabschnitt unterscheidet.

Bezüglich der Vorteile der erfindungsgemäßen Überlappungseinrichtung und vorteilhafter Ausgestaltungen der erfindungsgemäßen Überlappungseinrichtung gelten die obigen Ausführungen im Zusammenhang mit der erfindungsgemäßen Vorrichtung entsprechend. Dies bedeutet beispielsweise, dass die Ausgestaltung des Randelements und die des Zusatzrandelements sowie die Anordnung von Randelement und Zusatzrandelement so gewählt sein kann, wie dies oben im Zusammenhang mit der erfindungsgemäßen Vorrichtung sowie weiter unten im Zusammenhang mit der Figurenbeschreibung erläutert wird.

Die Überlappungseinrichtung ist vorzugsweise blendenhalterkompatibel, also dazu ausgestaltet, in einen Blendenhalter eines Elektronenmikroskops oder einer Elektronenholografiemesseinrichtung eingesetzt zu werden.

Die Erfindung wird nachfolgend anhand von Ausführungsbeispielen näher erläutert; dabei zeigen beispielhaft:

Figur 1 ein Ausführungsbeispiel für eine erfindungsgemäße Anordnung, die mit einem ein Randelement aufweisenden Ausführungsbeispiel für eine erfindungsgemäße Überlappungseinrichtung ausgestattet ist,

Figur 2 näher im Detail ein erstes Ausführungsbeispiel für das Randelement der Anordnung gemäß Figur 1, wobei eine Steuerelektrode des Randelements eine plane Endfläche aufweist,

Figur 3 näher im Detail ein zweites Ausführungsbeispiel für das Randelement der Anordnung gemäß Figur 1, wobei eine Steuerelektrode des Randelements eine Elektrodenspitze am Ende eines konischen Endbereichs der Steuerelektrode aufweist,

Figur 4 näher im Detail ein drittes Ausführungsbeispiel für das Randelement der Anordnung gemäß Figur 1, wobei eine Steuerelektrode des Randelements eine Elektrodenspitze am Ende eines konischen Endbereichs aufweist,

Figur 5 näher im Detail ein viertes Ausführungsbeispiel für das Randelement der Anordnung gemäß Figur 1, wobei eine Steuerelektrode des Randelements eine nach innen versetzte Elektrodenspitze am Ende eines konischen Endbereichs aufweist,

Figur 6 näher im Detail ein fünftes Ausführungsbeispiel für das Randelement der Anordnung gemäß Figur 1, wobei eine Steuerelektrode des Randelements eine nach innen versetzte Elektrodenspitze am Ende eines radial nach innen gewölbten Endbereichs aufweist, und

Figur 7 anhand des fünften Ausführungsbeispiels gemäß Figur 6 ein bevorzugtes Ausführungsbeispiel für eine erfindungsgemäße Überlappungseinrichtung, die für die Anordnung gemäß Figur 1 geeignet ist.

In den Figuren werden der Übersicht halber für identische oder vergleichbare Komponenten stets dieselben Bezugszeichen verwendet.

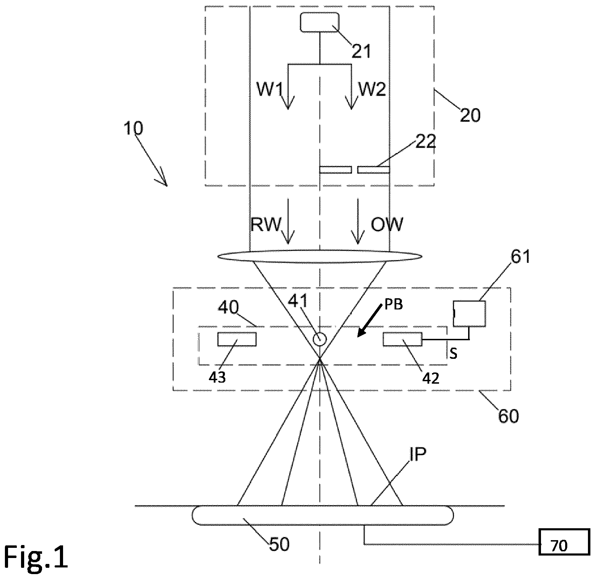

Die Figur 1 zeigt ein Ausführungsbeispiel für eine Vorrichtung 10, die für zeitaufgelöste interferometrische Messungen geeignet ist. Die Vorrichtung 10 kann ein Elektronenholografiesystem bilden oder darin enthalten sein.

Die Vorrichtung 10 umfasst eine Quelle 20 zur Erzeugung zweier kohärenter Elektronenwellen, die im Folgenden als Referenzwelle RW und Objektwelle OW bezeichnet werden. Die Quelle 20 weist zu diesem Zwecke einen Elektronenemitter 21 auf, der eine erste Teilelektronenwelle W1 und eine zweite Teilelektronenwelle W2 emittiert. Die erste Teilelektronenwelle W1 wird vorzugsweise durch Vakuum übertragen und bildet die Referenzwelle RW. Die zweite Teilelektronenwelle W2, die mit der ersten Teilelektronenwelle W1 kohärent ist, passiert ein Objekt 22 und bildet die Objektwelle OW.

Die Referenzwelle RW und die Objektwelle OW passieren ein Objektiv 30 und eine Überlappungseinrichtung 40.

Die Überlappungseinrichtung 40 überlappt die Referenzwelle RW und die Objektwelle OW und erzeugt ein Interferenzmuster IP, das von einer Messeinrichtung 50 gemessen und von einem Analysator 70 ausgewertet wird.

In der beispielhaften Ausführungsform gemäß Figur 1 umfasst die Überlappungsvorrichtung 40 einen Passierbereich PB, der von den sich überlappenden kohärenten Wellen passiert wird. Der Passierbereich PB wird durch ein strahlteilendes Element 41 im Mittenbereich des Passierbereiches PB in zwei Abschnitte unterteilt.

In der Figur 1 wird der Passierbereich PB am rechten Rand randseitig begrenzt durch ein Randelement 42, das mit einer aus Gründen der Übersicht nicht gezeigten Steuerelektrode ausgestattet ist. Die Steuerelektrode steht mit einer Störeinrichtung 61 in Verbindung und kann von dieser mit einem elektrischen Steuer- bzw. Störsignal S beaufschlagt werden. Die Steuerelektrode ist im Inneren eines Mantelabschnitts des Randelements 42 angeordnet.

Die aus der Störeinrichtung 61 und der Überlappungseinrichtung 40 gebildete Störeinheit ist in der Figur 1 mit dem Bezugszeichen 60 gekennzeichnet.

Dem Randelement 42 liegt ein Zusatzrandelement 43 gegenüber, das den Passierbereich PB auf der linken Seite der Figur 1 randseitig begrenzt.

Das strahlteilende Element 41, ein Mantelabschnitt des Randelements 42 und das Zusatzrandelement 43 sind elektrisch leitfähig und liegen vorzugsweise auf demselben elektrischen Potential, beispielsweise dem Erdpotential. Alternativ können das strahlteilende Element 41, der Mantelabschnitt des Randelements 42 und das Zusatzrandelement 43 auf unterschiedlichen Potentialen liegen.

Bei dem Ausführungsbeispiel gemäß Figur 1 beeinflusst das von der Störeinrichtung 61 ansteuerbare bzw. angesteuerte Randelement 42 primär die Objektwelle OW, weil diese den Bereich zwischen dem Randelement 42 und dem strahlteilenden Element 41 passiert, wohingegen die Referenzwelle RW den Bereich zwischen dem Gegenrandelement 43 und dem strahlteilenden Element 41 passiert. Alternativ kann die Anordnung des Randelements 42 und des Gegenrandelements 43 auch umgekehrt sein: In einem solchen Falle würde das von der Störeinrichtung 61 ansteuerbare Randelement 42 primär die Referenzwelle RW beeinflussen, weil diese den Bereich zwischen dem Randelement 42 und dem strahlteilenden Element 41 passieren würde, wohingegen die Objektwelle OW den Bereich zwischen dem Gegenrandelement 43 und dem strahlteilenden Element 41 passieren würde.

Im Übrigen ist es möglich, zusätzlich auch das Gegenrandelement 43 ansteuerbar auszugestalten, beispielsweise genauso ansteuerbar wie das Randelement 42, um eine Beeinflussbarkeit beider Wellen, also der Objektwelle OW und der Referenzwelle RW zu ermöglichen. Im letztgenannten Fall ist es von Vorteil, wenn das Gegenrandelement 43 mit einer eigenen Störeinrichtung verbunden ist, die in der Figur 1 nicht gezeigt ist und ein sich von dem Steuersignal S der Störeinrichtung 61 unterscheidendes weiteres Steuersignal erzeugt.

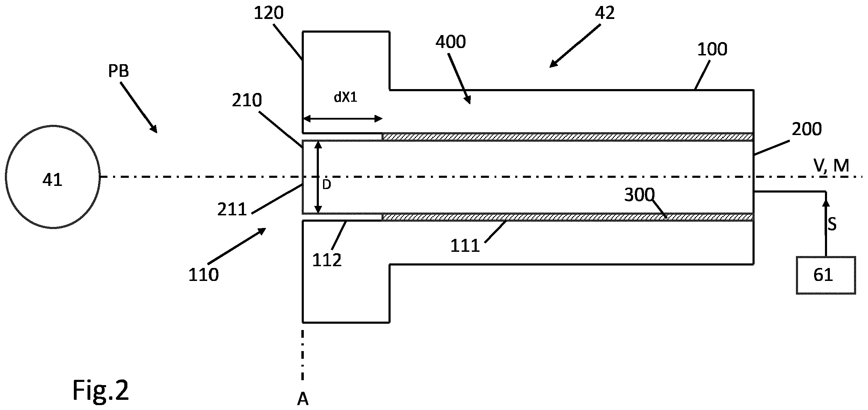

Die Figur 2 zeigt ein erstes Ausführungsbeispiel für ein Randelement 42, das als das Randelement 42 in der Anordnung gemäß Figur 1 eingesetzt werden kann, näher im Detail.

Es lässt sich erkennen, dass ein elektrisch leitfähiger, flanschförmiger Mantelabschnitt 100 des Randelements 42 mit einem Durchgangsloch 110 ausgestattet ist, dessen Innenwand 111 von der im Durchgangsloch 110 befindlichen Steuerelektrode 200 durch einen elektrischen Isolator 300 elektrisch getrennt ist. Die Steuerelektrode 200 und der von dieser elektrisch getrennte Mantelabschnitt 100 bilden gemeinsam einen elektrischen Koaxialleiter 400, der aufgrund seiner Dimensionierung zur Übertragung von hochfrequenten elektrischen Signalen wie beispielsweise solchen im Radio- oder Mikrowellenfrequenzbereich, also für Frequenzen zwischen 5 KHz und 50 GHz geeignet ist.

Für eine Übertragung von Signalen für hochfrequente elektrische Signale im Radio- oder Mikrowellenfrequenzbereich werden folgende Dimensionierungen und Eigenschaften des Randelements 42 als vorteilhaft angesehen:

$$10 \ \mu m < D < 1000 \ \mu m$$

$$10 \ \mu m < Dicke \ der \ Isolatorschicht < 500 \ \mu m$$

Material des Isolators 300: Polyethylen oder Polytetrafluoroethylene
Material der Steuerelektrode 200: Vergoldetes Kupfer
Material des Mantelabschnitts 100: Edelstahl (amagnetisch)

Die Störeinrichtung 61 ist somit in der Lage, zur Störung der Interferenz der Elektronenwellen ein hochfrequentes elektrisches Steuersignal S im Radiowellen- oder Mikrowellenbereich über den Koaxialleiter 400 einzuspeisen und im Bereich des an den Passierbereich PB angrenzenden Endabschnitt 112 des Durchgangslochs 110 ein hochfrequentes elektrisches Wechselfeld zu erzeugen, mit dem sich die Interferenz der Elektronenwellen mit entsprechend hoher Frequenz stören lässt. Bei der elektrischen Spannung, die von der Störeinrichtung 61 erzeugt und über den Koaxialleiter 400 übertragen wird, handelt es sich vorzugsweise um eine Wechselspannung im Frequenzbereich zwischen 10 kHz und 1 GHz.

Bei der Störeinrichtung 61 kann es sich beispielsweise um einen Rauschgenerator handeln, der als Steuersignal S ein hochfrequentes Rauschsignal erzeugt.

Bei dem Ausführungsbeispiel gemäß Figur 2 erstreckt sich die Mittelachse M des Durchgangslochs 110 und damit die der Steuerelektrode 200 in Richtung des strahlteilenden Elements 41. Eine fiktive Verbindungslinie V zwischen dem dem Passierbereich PB zugewandten Elektrodenende 210 der Steuerelektrode 200 und dem zu diesem nächstliegenden Abschnitt des strahlteilenden Elements 41 liegt vorzugsweise auf der Mittelachse M.

Um eine effiziente Ausbildung eines die Interferenz störenden Störfeldes zu unterstützen, ist bei dem Ausführungsbeispiel gemäß Figur 2 der an den Passierbereich PB angrenzende Endabschnitt 112 des Durchgangslochs 110 isolatorfrei. Die Länge dX1 des isolatorfreien Endabschnitts 112 liegt vorzugsweise zwischen dem 0,75-Fachen und 1,25-Fachen des Durchmessers D der Steuerelektrode 200:

$$0{,}75 * D < dX1 < 1{,}25 * D.$$

Bei dem Ausführungsbeispiel gemäß Figur 2 ist das dem Passierbereich PB zugewandte Elektrodenende 210 der Steuerelektrode 200 plan und weist eine senkrecht zur Mittelachse M angeordnete plane Endfläche 211 auf, die in derselben Ebene, hier der Ebene A der Außenfläche 120 des Mantelabschnitts 100, wie die den Passierbereich PB begrenzende Außenfläche 120 des Mantelabschnitts 100 liegt.

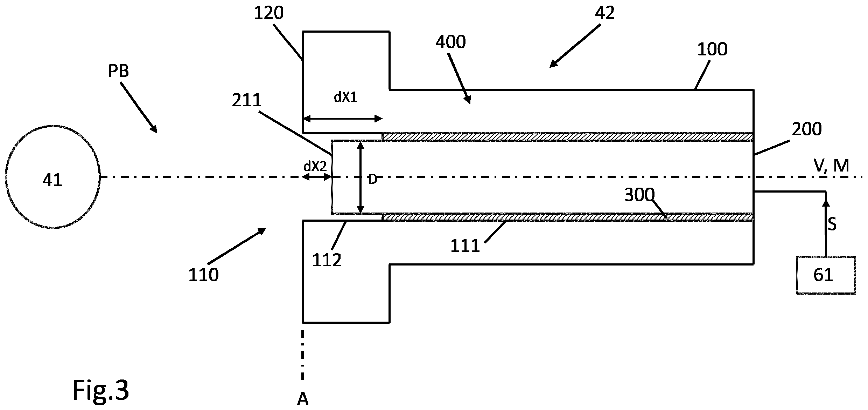

Die Figur 3 zeigt ein zweites Ausführungsbeispiel für ein Randelement 42, das als das Randelement 42 in der Anordnung gemäß Figur 1 eingesetzt werden kann.

Bei dem zweiten Ausführungsbeispiel gemäß Figur 3 ist das dem Passierbereich PB zugewandte Elektrodenende 210 der Steuerelektrode 200 ebenfalls plan und weist ebenfalls eine senkrecht zur Mittelachse M angeordnete plane Endfläche 211 auf; insoweit entsprechen sich das erste und zweite Ausführungsbeispiel.

Anders als bei dem ersten Ausführungsbeispiel gemäß Figur 2 ist bei dem zweiten Ausführungsbeispiel gemäß Figur 3 das dem Passierbereich PB zugewandte Elektrodenende 210 der Steuerelektrode 200 im Inneren des Durchgangslochs 110, also nach innen versetzt, angeordnet und liegt somit nicht in derselben Ebene wie die den Passierbereich PB begrenzende Außenfläche 120 des Mantelabschnitts 100.

Mit Blick auf eine besonders effiziente Ausbildung des Störfeldes weist das Elektrodenende 210 einen Abstand dX2 von der an den Passierbereich PB angrenzenden Außenfläche 120 des Mantelabschnitts 100 auf; der Abstand dX2 liegt vorzugsweise zwischen dem 0,5-Fachen und 1,0-Fachen des Durchmessers der Steuerelektrode 200:

$$0{,}5 * D < dX2 < D.$$

Bezüglich der Länge des isolatorfreien Mantelabschnitts 100 bzw. der Länge dX1 des isolatorfreien Endabschnitts 112 des Durchgangslochs 110 gilt vorzugsweise wieder:

$$0{,}75 * D < dX1 < 1{,}25 * D.$$

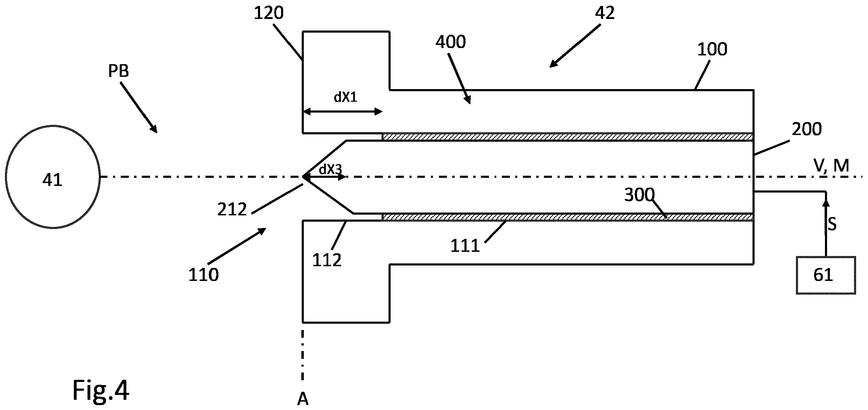

Die Figur 4 zeigt ein drittes Ausführungsbeispiel für ein Randelement 42, das als das Randelement 42 in der Anordnung gemäß Figur 1 eingesetzt werden kann, näher im Detail.

Das dritte Ausführungsbeispiel unterscheidet sich von dem ersten und zweiten Ausführungsbeispiel dahingehend, dass das dem Passierbereich PB zugewandte Elektrodenende 210 der Steuerelektrode 200 nicht plan ist, sondern durch eine Elektrodenspitze 212 gebildet ist. Der Endbereich der Steuerelektrode 200 ist kreiskegel- oder kreiskegelstumpfförmig und rotationssymmetrisch bezüglich der Mittelachse M.

Die Länge dX3 des sich verjüngenden Endbereichs ist - entlang der Mittelachse M des Durchgangslochs 110 gesehen - kleiner als die Hälfte des Durchmessers D der Steuerelektrode 200:

$$dX3 < D/2.$$

Bezüglich der Länge des isolatorfreien Mantelabschnitts 100 bzw. der Länge dX1 des isolatorfreien Endabschnitts des Durchgangslochs 110 gilt vorzugsweise wieder:

$$0{,}75 * D < dX1 < 1{,}25 * D.$$

Bei dem dritten Ausführungsbeispiel gemäß Figur 4 liegt die dem Passierbereich PB zugewandte Elektrodenspitze 212 der Steuerelektrode 200 in derselben Ebene A wie die den Passierbereich PB begrenzende Außenfläche 120 des Mantelabschnitts 100.

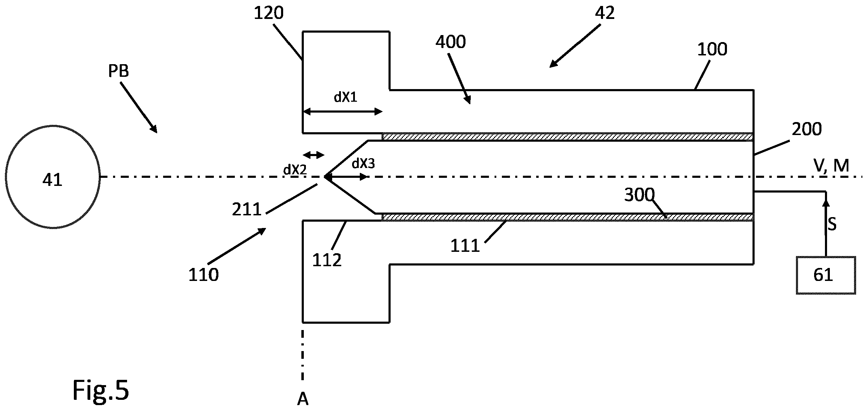

Die Figur 5 zeigt ein viertes Ausführungsbeispiel für ein Randelement 42, das als das Randelement 42 in der Anordnung gemäß Figur 1 eingesetzt werden kann.

Bei dem vierten Ausführungsbeispiel gemäß Figur 5 ist der dem Passierbereich PB zugewandte Endbereich der Steuerelektrode 200 ebenfalls unter Bildung einer Elektrodenspitze 212 spitz zulaufend; insoweit entsprechen sich das dritte und vierte Ausführungsbeispiel.

Anders als bei dem dritten Ausführungsbeispiel gemäß Figur 4 ist bei dem vierten Ausführungsbeispiel gemäß Figur 5 die dem Passierbereich PB zugewandte Elektrodenspitze 212 der Steuerelektrode 200 im Inneren des Durchgangslochs 110 angeordnet und liegt somit nicht in derselben Ebene wie die den Passierbereich PB begrenzende Außenfläche 120 des Mantelabschnitts 100.

Mit Blick auf eine besonders effiziente Ausbildung des Störfeldes weist die Elektrodenspitze 212 einen Abstand dX2 von der an den Passierbereich PB angrenzenden Außenfläche 120 des Mantelabschnitts 100 auf; der Abstand dX2 liegt vorzugsweise zwischen dem 0,5-Fachen und 1,0-Fachen des Durchmessers der Steuerelektrode 200:

$$0,5 * D < dX2 < D.$$

Bezüglich der Länge des isolatorfreien Mantelabschnitts 100 bzw. der Länge dX1 des isolatorfreien Endabschnitts des Durchgangslochs 110 gilt vorzugsweise wieder:

$$0,75 * D < dX1 < 1,25 * D.$$

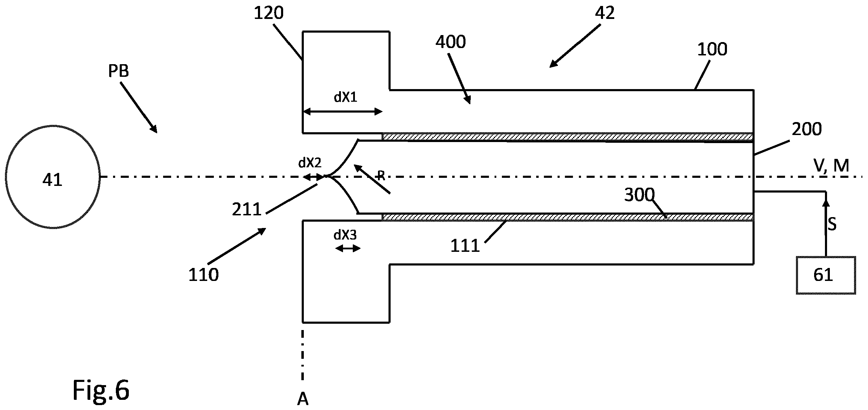

Die Figur 6 zeigt ein fünftes Ausführungsbeispiel für ein Randelement 42, das als das Randelement 42 in der Anordnung gemäß Figur 1 eingesetzt werden kann.

Das fünfte Ausführungsbeispiel weist ebenfalls eine Elektrodenspitze 212 auf, aber unterscheidet sich von dem dritten und vierten Ausführungsbeispiel dahingehend, dass der dem Passierbereich PB zugewandte Endbereich der Steuerelektrode 200 nicht kreiskegel- oder kreiskegelstumpfförmig ist, sondern eine äußere Fläche aufweist, die in Richtung der Mittelachse M, die eine Rotationsachse bildet, radial nach innen gewölbt ist. Der Wölbungsradius R der Wölbung ist vorzugsweise kleiner als der Durchmesser D der Steuerelektrode 200:

$$0 < R < D$$

Die Länge dX3 des sich verjüngenden Endbereichs der Steuerelektrode 200 ist - entlang der Längs- bzw. Mittelachse M des Durchgangslochs 110 gesehen - vorzugsweise kleiner als die Hälfte des Durchmessers D der Steuerelektrode 200:

$$dX3 < D/2.$$

Bezüglich der Länge des isolatorfreien Mantelabschnitts 100 bzw. der Länge dX1 des isolatorfreien Durchgangslochs 110 gilt vorzugsweise wieder:

$$0,75 * D < dX1 < 1,25 * D.$$

Die Mantelabschnitte 100 des Randelements 42 sind vorzugsweise flanschförmig, wie die Figuren 2 bis 5 beispielhaft zeigen.

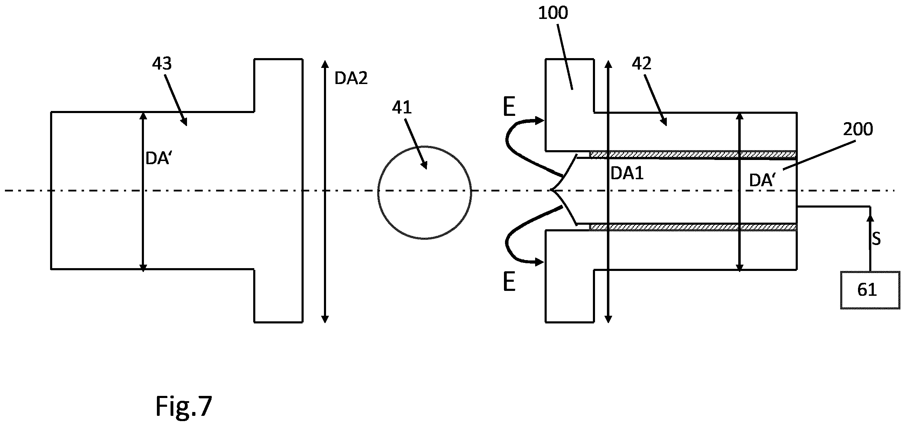

Die Figur 7 zeigt ein Ausführungsbeispiel für eine erfindungsgemäße Überlappungseinrichtung 40, die bei der Anordnung gemäß Figur 1 eingesetzt werden kann.

Die Überlappungseinrichtung 40 gemäß Figur 7 umfasst ein Randelement 42, beispielsweise das Randelement 42 gemäß Figur 6, das in Figur 1 gezeigte Zusatzrandelement 43 und das in Figur 1 gezeigte strahlteilende Element 41.

Anstelle des in der Figur 7 gezeigten Randelements 42 gemäß Figur 6 kann die Überlappungseinrichtung 40 auch ein anders gestaltetes Randelement, wie beispielsweise eines der Randelemente 42 gemäß den Figuren 2 bis 5, aufweisen.

Aus Symmetriegründen ist es von Vorteil, wenn der Außendurchmesser DA1 des Mantelabschnitts 100 des Randelements 42 genauso groß ist wie der Außendurchmesser DA2 des Zusatzrandelements 43, wie die Figur 7 am Beispiel des Randelements 42 gemäß Figur 6 näher zeigt.

Aus Symmetriegründen ist auch vorteilhaft, wenn das Zusatzrandelement 43 ebenfalls flanschförmig ausgestaltet ist, also die äußere Form des Zusatzrandelements 43 und die äußere Form des Mantelabschnitts 100 des Randelements 42 identisch geformt und dimensioniert sind.

Von Vorteil ist es, wenn für den Außendurchmesser DA' des Randelements 42 in dem an den Flanschbereich angrenzenden Mittenbereich des Randelements 42 folgende Beziehung gilt:

$$DA' < DA1 / 2.$$

Entsprechendes gilt für den Außendurchmesser DA' des Zusatzrandelements 43 in dem an den Flanschbereich angrenzenden Mittenbereich.

Die Figur 7 zeigt außerdem in sehr vereinfachter Form und nur schematisch zwei Feldlinien des elektrischen Feldes, die zwischen der Steuerelektrode 200 und dem Mantelabschnitt 100 des Randelements 42 von dem Störsignal S hervorgerufen werden können, um die Interferenz der Elektronenwellen - anschaulich durch ein Verschieben der Elektronenstrahlen durch Anziehung oder Abstoßen der Elektronen der Elektronenstrahlen - zu stören.

Ähnliche elektrische Felder entstehen im Übrigen zwischen der Steuerelektrode 200 und dem Mantelabschnitt 100 des Randelements 42 bei den Ausführungsbeispielen gemäß den Figuren 2 bis 5, sobald eine elektrische Spannung zwischen der Steuerelektrode 200 und dem Mantelabschnitt 100 angelegt wird.

Abschließend sei erwähnt, dass die Merkmale aller oben beschriebenen Ausführungsbeispiele untereinander in beliebiger Weise kombiniert werden können, um weitere andere Ausführungsbeispiele der Erfindung zu bilden.

Auch können alle Merkmale von Unteransprüchen jeweils für sich mit jedem der nebengeordneten Ansprüche kombiniert werden, und zwar jeweils für sich allein oder in beliebiger Kombination mit einem oder mehreren anderen Unteransprüchen, um weitere andere Ausführungsbeispiele zu erhalten.

Bezugszeichenliste

| | |
|---|---|
| 10 | Vorrichtung |
| 20 | Quelle |
| 21 | Elektronenemitter |
| 22 | Objekt |
| 30 | Objektiv |
| 40 | Überlappungseinrichtung |
| 41 | strahlteilendes Element |
| 42 | Randelement |
| 43 | Zusatzrandelement |
| 50 | Messeinrichtung |
| 60 | Störeinheit |
| 61 | Störeinrichtung |
| 70 | Analysator |
| 100 | Mantelabschnitt |
| 110 | Durchgangsloch |
| 111 | Innenwand |
| 112 | Endabschnitt |
| 120 | Außenfläche |
| 200 | Steuerelektrode |
| 210 | Elektrodenende |
| 211 | plane Endfläche |
| 212 | Elektrodenspitze |
| 300 | Isolator |
| 400 | Koaxialleiter |

| | |
|---|---|
| A | Ebene |
| dX1 | Länge |
| dX2 | Abstand |
| dX3 | Länge |
| D | Durchmesser |
| DA1 | Außendurchmesser |
| DA2 | Außendurchmesser |
| DA' | Außendurchmesser |

IP      Interferenzmuster
M       Mittelachse
OW      Objektwelle
PB      Passierbereich
R       Wölbungsradius
RW      Referenzwelle
S       elektrisches Steuersignal
V       Verbindungslinie
W1      erste Teilelektronenwelle
W2      zweite Teilelektronenwelle

**Patentansprüche**

1.  Vorrichtung (10) zur Durchführung einer interferometrischen Messung mit

    - einer Quelle (20) zur Erzeugung von mindestens zwei kohärenten Wellen (OW, RW),
    - einer Überlappungseinrichtung (40) zum Überlappen der mindestens zwei kohärenten Wellen (OW, RW) und zum Erzeugen eines Interferenzmusters (IP),
    - einer Messeinrichtung (50) zum Messen des Interferenzmusters (IP) unter Bildung gemessener Interferenzwerte (I(x,y)),
    - einer Störeinrichtung (61) zum Stören des Interferenzmusters (IP) und
    - einem Analysator (70) zum Analysieren der gemessenen Interferenzwerte (I(x,y)),
    - wobei die Überlappungseinrichtung (40) einen von einem Randelement (42) randseitig begrenzten Passierbereich (PB), der von den mindestens zwei sich überlappenden kohärenten Wellen passiert wird, und ein strahlteilendes Element (41) im Mittenbereich des Passierbereiches (PB) umfasst,
    **dadurch gekennzeichnet, dass**
    - das Randelement (42) einen elektrisch leitfähigen Mantelabschnitt (100) mit einem Durchgangsloch (110) aufweist, dessen Innenwand (112) von einer im Durchgangsloch (110) befindlichen Steuerelektrode (200) des Randelements (42) durch einen Isolator (300) elektrisch getrennt ist, und
    - die Störeinrichtung (61) mit der Steuerelektrode (200) elektrisch in Verbindung steht und geeignet ist, zur Störung der Interferenz eine elektrische Spannung zwischen den Mantelabschnitt (100) und die Steuerelektrode (200) anzulegen.

2.  Vorrichtung nach Anspruch 1,
    **dadurch gekennzeichnet, dass**
    sich die Mittelachse (M) des Durchgangslochs (110) in Richtung des strahlteilenden Elements (41) erstreckt und eine fiktive Verbindungslinie (V) zwischen einem dem Passierbereich (PB) zugewandten Elektrodenende (210) der Steuerelektrode (200) und einem zu diesem nächstliegenden Abschnitt des strahlteilenden Elements (41) auf der Mittelachse (M) liegt.

3.  Vorrichtung nach einem der voranstehenden Ansprüche, **dadurch gekennzeichnet, dass**

    - ein an den Passierbereich (PB) angrenzender Endabschnitt des Durchgangslochs (110) isolatorfrei ist und
    - die Länge (dX1) des isolatorfreien Endabschnitts zwischen dem 0,75-Fachen und 1,25-Fachen des Durchmessers (D) der Steuerelektrode (200) liegt.

4.  Vorrichtung nach einem der voranstehenden Ansprüche,
    **dadurch gekennzeichnet, dass**
    ein dem Passierbereich (PB) zugewandtes Elektrodenende (210) der Steuerelektrode (200) im Inneren des Durchgangslochs (110) liegt und einen Abstand von der den Passierbereich (PB) begrenzenden Außenfläche (120) des Mantelabschnitts (100) aufweist.

5.  Vorrichtung nach Anspruch 4,
    **dadurch gekennzeichnet, dass**
    der Abstand (dX2) zwischen dem Elektrodenende (210) und der Außenfläche (120) des Mantelabschnitts (100) zwischen dem 0,5-Fachen und 1,0-Fachen des Durchmessers (D) der Steuerelektrode (200) liegt.

6.  Vorrichtung nach einem der voranstehenden Ansprüche,

**dadurch gekennzeichnet, dass**
die Steuerelektrode (200) einen sich in Richtung des Passierbereichs (PB) verjüngenden Endbereich aufweist.

7. Vorrichtung nach Anspruch 6,
   **dadurch gekennzeichnet, dass**
   die Länge (dX3) des sich verjüngenden Endbereichs entlang der Längsachse des Durchgangslochs (110) gesehen kleiner als die Hälfte des Durchmessers (D) der Steuerelektrode (200) ist.

8. Vorrichtung nach einem der voranstehenden Ansprüche 6 bis 7,
   **dadurch gekennzeichnet, dass**
   der Endbereich rotationssymmetrisch ist und/oder sich konisch verjüngt.

9. Vorrichtung nach einem der voranstehenden Ansprüche 6 bis 8,
   **dadurch gekennzeichnet, dass**
   der Endbereich kreiskegel- oder kreiskegelstumpfförmig ist.

10. Vorrichtung nach einem der voranstehenden Ansprüche 6 bis 9,
    **dadurch gekennzeichnet, dass**
    die äußere Fläche des Endbereichs in Richtung einer Rotationsachse radial nach innen gewölbt ist.

11. Vorrichtung nach Anspruch 10,
    **dadurch gekennzeichnet, dass**
    der Wölbungsradius (R) der Wölbung kleiner als der Durchmesser (D) der Steuerelektrode (200) ist.

12. Vorrichtung nach einem der voranstehenden Ansprüche,
    **dadurch gekennzeichnet, dass**
    dem Randelement (42) ein Zusatzrandelement (43) gegenüberliegt und das strahlteilende Element (41) zwischen dem Randelement (42) und dem Zusatzrandelement (43) angeordnet ist.

13. Vorrichtung nach einem der voranstehenden Ansprüche,
    **dadurch gekennzeichnet, dass**
    die Vorrichtung eine Elektronenholografiemesseinrichtung und die Quelle eine Elektronenstrahlquelle ist.

14. Überlappungseinrichtung für eine Vorrichtung, beispielsweise eine solche nach einem der voranstehenden Ansprüche, wobei die Überlappungseinrichtung (40) einen von einem Randelement (42) randseitig begrenzten Passierbereich (PB), der von sich überlappenden kohärenten Wellen passierbar ist, und ein strahlteilendes Element (41) im Mittenbereich des Passierbereichs (PB) umfasst,
    **dadurch gekennzeichnet, dass**

    - das Randelement (42) einen elektrisch leitfähigen Mantelabschnitt (100) mit einem Durchgangsloch (110) aufweist, dessen Innenwand (112) von einer im Durchgangsloch (110) befindlichen Steuerelektrode (200) des Randelements (42) durch einen Isolator (300) elektrisch getrennt ist, und
    - die Steuerelektrode (200) einen Anschluss aufweist, an den zur Störung einer Interferenz ein elektrisches Potential anlegbar ist, das sich vom elektrischen Potential an dem Mantelabschnitt (100) unterscheidet.

15. Überlappungseinrichtung nach Anspruch 14,
    **dadurch gekennzeichnet, dass**

    - dem Randelement (42) ein Zusatzrandelement (43) gegenüberliegt und ein strahlteilendes Element (41) zwischen dem Randelement (42) und dem Zusatzrandelement (43) angeordnet ist und
    - die Überlappungseinrichtung derart dimensioniert und dazu ausgestaltet ist, in einen Blendenhalter einer Elektronenholografiemesseinrichtung oder eines Elektronenstrahlmikroskops eingesetzt zu werden.

Fig.1

Fig.2

Fig.3

Fig.4

Fig.5

Fig.6

EP 4 513 526 A1

Fig.7

Europäisches
Patentamt

European
Patent Office

Office européen
des brevets

# EUROPÄISCHER RECHERCHENBERICHT

**Nummer der Anmeldung**

**EP 23 19 3463**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 2012/241612 A1 (HARADA KEN [JP] ET AL) 27. September 2012 (2012-09-27) | 14,15 | INV. H01J37/26 |
| A | * Figuren 6, 10, 11, 13 und zugehöriger Text; Absätze [0011], [0025] * ----- | 1-13 | ADD. G03H1/04 G03H5/00 |

**RECHERCHIERTE SACHGEBIETE (IPC)**

H01J

Der vorliegende Recherchenbericht wurde für alle Patentansprüche erstellt

| Recherchenort | Abschlußdatum der Recherche | Prüfer |
|---|---|---|
| München | 8. Februar 2024 | Krauss, Jan |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus anderen Gründen angeführtes Dokument
    ...........................................................................
& : Mitglied der gleichen Patentfamilie, übereinstimmendes
    Dokument

EPO FORM 1503 03.82 (P04C03)

18

**EP 4 513 526 A1**

## ANHANG ZUM EUROPÄISCHEN RECHERCHENBERICHT
## ÜBER DIE EUROPÄISCHE PATENTANMELDUNG NR.

EP 23 19 3463

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

08-02-2024

| Im Recherchenbericht angeführtes Patentdokument | Datum der Veröffentlichung | Mitglied(er) der Patentfamilie | Datum der Veröffentlichung |
|---|---|---|---|
| US 2012241612 A1 | 27-09-2012 | JP 5420678 B2 | 19-02-2014 |
| | | JP WO2011071015 A1 | 22-04-2013 |
| | | US 2012241612 A1 | 27-09-2012 |
| | | WO 2011071015 A1 | 16-06-2011 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 3376522 A1